# DEMANDE DE BREVET EUROPEEN

(11) **EP 0 871 291 A1**
(43) Date de publication de la demande: **14.10.1998**
(21) Numéro de dépôt: 98400832.6
(22) Date de dépôt: 07.04.1998
(51) Int. Cl.: H03K 19/013, H03F 3/45

(54) **Amplificateur de précision pour signaux impulsionnels**

(30) Priorité: 09.04.1997 FR 9704348
(71) Demandeur: COMMISSARIAT A L'ENERGIE ATOMIQUE, 75015 Paris (FR)
(72) Inventeur: Masson, Gilles, 38950 Saint Martin Le Vinoux (FR)
(74) Mandataire: Moutard, Pascal Jean

(57) **Abrégé**

L'invention concerne un dispositif d'amplification différentielle comportant :
- un premier étage (14) ayant une première et une seconde entrée (15, 17) et une sortie (19), cet étage permettant d'amplifier une différence de tension entre un signal (EM) appliqué à la première entrée (15) et un signal (EP) appliqué à la deuxième entrée (17),
- un second étage présentant une entrée et une sortie (41), l'entrée de ce second étage étant connecté à la sortie (19) du premier étage, ce second étage comportant également un transistor (30) polarisé par une source de courant continu (26) ainsi que des moyens (29) pour bloquer la source de courant continu (26) lors du front montant d'une impulsion de tension (EM).

## Description

### Domaine technique et art antérieur

L'invention concerne le domaine des amplificateurs de précision pour signaux impulsionnels.

En particulier, l'invention concerne une nouvelle architecture d'amplificateur opérationnel qui, chargé sur une capacité, est particulièrement bien adapté au suivi de signaux impulsionnels de fortes amplitudes à larges bandes passantes et possède une bonne précision et une consommation statique modérée.

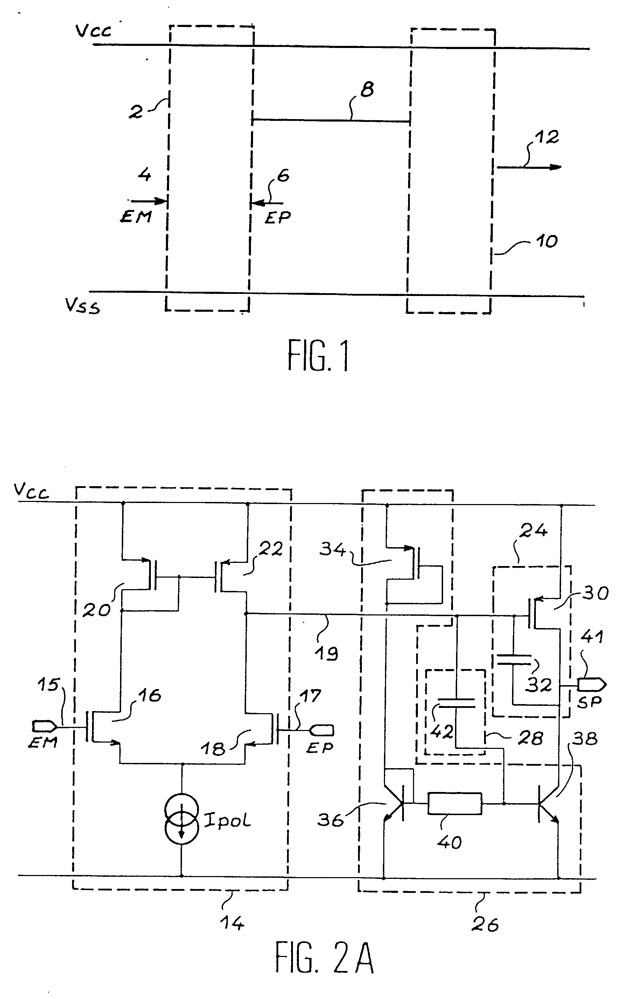

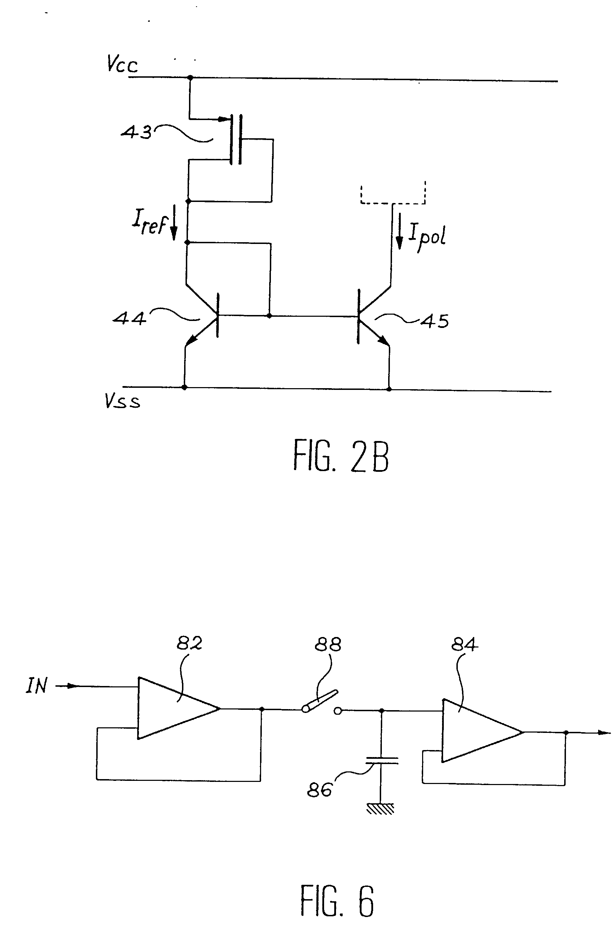

On connaît des dispositifs amplificateurs pour signaux impulsionnels dont la structure est schématisée sur la figure 1. Un premier étage 2 d'amplification est polarisé entre deux rails de tension V_{cc} et Vₛₛ. Un signal continu EP est fourni sur une entrée 6 et une impulsion de tension sur une entrée 4 de l'étage d'amplification. Une sortie 8 de cet étage commande un deuxième étage qui intègre une source de courant continu (MOS) et fournit un signal de sortie 12.

Ces dispositifs ont des "slew-rate" (ou variation de tension en fonction du temps ; cette grandeur mesure l'aptitude de l'amplificateur à suivre une impulsion) de l'ordre de 600 V/s, et une large bande passante. Ils ne permettent pas de suivre une impulsion de l'ordre de grandeur de la nanoseconde.

Dans le domaine de l'amplification linéaire de signaux impulsionnels à larges bandes passantes et à fortes amplitudes, on fait aussi appel soit :
- à des structures en boucle ouverte qui ne permettent pas d'atteindre de très bonnes précisions à cause de l'offset et du gain, qui sont médiocres et difficilement contrôlable,
- à des structures "push-pull inversé", qui sont trop lentes.

Toutes les autres techniques classiques d'amélioration du slew-rate ne permettent en aucun cas d'atteindre les performances souhaitées à la fois en impulsionnel et en précision. C'est le cas notamment des structures à asservissement continu de la polarisation de l'étage de sortie.

Le problème posé est de trouver une architecture d'amplificateur qui permet de combiner un fort slew-rate, notamment sur une large gamme de tensions, et éventuellement une bonne précision, c'est-à-dire un gain DC assez élevé avec une bonne stabilité.

### Exposé de l'invention

L'invention a pour objet dispositif d'amplification différentielle, comportant :
- un premier étage ayant une première et une seconde entrée et une sortie, cet étage permettant d'amplifier une différence de tension entre un signal appliqué à la première entrée et un signal appliqué à la deuxième entrée,
- un second étage présentant une entrée et une sortie, l'entrée de ce second étage étant connecté à la sortie du premier étage, ce second étage comportant également un transistor polarisé par une source de courant continu ainsi que des moyens pour bloquer la source de courant continu lors du front montant d'une impulsion de tension.

L'invention a également pour objet un dispositif de suivi de signaux impulsionnels analogiques selon la revendication 1.

Chacun de ces dispositifs possède deux modes de fonctionnement grâce aux moyens permettant de bloquer la source de courant continu : en mode normal la précision statique est grande grâce aux deux étages de gain ; en mode impulsionnel le slew-rate est très élevé grâce à ces moyens de blocage agissant sur la polarisation de l'étage de sortie.

Ce moyen permet uniquement de bloquer la source.

Les moyens pour bloquer la source de courant continu lors du front montant d'une impulsion de tension peuvent aussi permettre une amplification du courant de la source de courant continu lors du front descendant d'une impulsion de tension.

Il en résulte alors un accroissement du slew-rate de descente.

Des moyens peuvent en outre être prévus pour stabiliser le transistor du second étage.

Les moyens pour bloquer la source de courant lors du front montant d'une impulsion de tension comportent, dans un mode de réalisation particulier, une capacité connectée entre la sortie du premier étage et la source de courant.

Enfin, la source de courant continu de l'étage de sortie peut comporter :
- des moyens pour générer un courant de référence,
- des moyens pour recopier ce courant,
- des moyens pour amplifier ce courant.

Le dispositif de suivi de signaux impulsionnels analogiques selon l'invention, tel que défini ci-dessus est monté en suiveur. Il permet notamment de réaliser une impédance pour augmenter un courant de charge, par exemple sur une capacité. Il permet également de faire du suivi de tension ou de l'échantillonnage.

Ce dispositif amplificateur transmet rapidement des signaux analogiques sans altérer leur forme. Le montage en boucle fermée permet d'obtenir une bonne précision.

Le dispositif selon l'invention peut être en particulier appliqué à un circuit échantillonneur-bloqueur où il assure la fonction de buffer d'entrée et de sortie.

Un tel circuit peut lui-même être appliqué à un télémètre et à un dispositif échantillonneur-bloqueur.

### Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :
- la figure 1 représente schématiquement une architecture d'un amplificateur opérationnel selon l'art antérieur,
- la figure 2A représente une réalisation d'un amplificateur opérationnel selon l'invention,
- la figure 2B représente des moyens de polarisation du premier étage,
- la figure 3 représente un montage en mode suiveur, chargé sur une capacité,
- la figure 4 représente une forme d'impulsion de tension,
- la figure 5 représente schématiquement un dispositif de télémétrie
- la figure 6 représente schématiquement un échantillonneur-bloqueur selon l'invention.

### Description détaillée de modes de réalisation de l'invention

Un exemple d'un amplificateur selon l'invention est illustré sur la figure 2.

Un premier étage 14 permet d'amplifier une différence de tension entre un premier signal EM (impulsion) appliqué à une première entrée 15 et un second signal EP appliqué à une seconde entrée 17 du premier étage. Ce second signal peut refléter le signal SP de sortie du dispositif, la sortie 41 de celui-ci étant par exemple connectée sur la seconde entrée 17.

Ce premier étage est alimenté par une première tension positive V_{cc} et peut être connecté à la masse (Vₛₛ=0). Il comporte plus précisément deux transistors de commande 16, 18, connectés chacun à une des entrées 15, 17, et des moyens de charge constitués par exemple de transistors de charge 20, 22.

Afin de conférer à l'amplificateur une très grande impédance d'entrée, il est préférable d'utiliser des transistors MOS en commande de l'étage différentiel constitué par les deux transistors 16, 18.

La charge active du premier étage peut être constituée de résistances. Mais l'utilisation, à la place de ces résistances, de transistors PMOS 20, 22 permet de conférer un gain beaucoup plus important par rapport au cas où on utilise des résistances. On peut également utiliser des transistors PNP, mais ils réduisent la dynamique haute de sortie à V_{cc}-0,3 volts environ. Dans les autres cas, la dynamique de sortie haute vaut V_{cc}.

Des moyens de polarisation de ce premier étage, peuvent être conçus par exemple avec des transistors NPN. Ceci permet de réaliser une polarisation présentant de bonnes performances dynamiques.

Schématiquement, ces moyens peuvent avoir la forme illustrée sur la figure 2B. Un transistor 43 est monté en résistance. Le courant Iₚₒₗ=nxI_{ref}, où n est le rapport des géométries des transistors 45 et 44.

Le second étage de gain est alimenté par la tension V_{cc} et est connecté par exemple à la masse (Vₛₛ=0). Il comporte un transistor de sortie 30, monté en source commune ainsi que des moyens 26 de polarisation, constitués sur la figure 2 par une source de courant continu. Cette dernière comporte par exemple deux transistors 36, 38, dont les bases respectives sont reliées par une résistance 40, et un transistor 34.

L'un des deux transistors 36, 38, génère un courant de référence, l'autre permet de recopier ce courant. Le transistor 34 est monté en résistance et permet de fixer le courant de référence dans la branche 34-36.

La grille de l'amplificateur 30 du second étage est reliée à la sortie 19 du premier étage 14. Une capacité 32, utilisée en effet Miller sur le transistor 30, permet d'assurer la stabilité de l'amplificateur.

Un couplage AC est assuré par une capacité 42, connectée entre la sortie 19 du premier étage et la base du transistor 38.

Le transistor de sortie 30 est de préférence un transistor PMOS, ce qui permet de réduire l'offset systématique, en ajustant sa géométrie par rapport à celle des transistors PMOS 20, 22 et aux courants de polarisation. L'utilisation de transistors PNP est également possible : mais elle réduit, là aussi, la dynamique haute de sortie à V_{cc}-0,3 volts environ et, de plus, l'offset est plus difficile à contrôler. La dynamique haute de sortie vaut V_{cc} avec des PMOS.

Afin de conférer de très bonnes performances dynamiques à la source de courant de l'étage de sortie, il est préférable que les transistors 36, 38 soient des transistors NPN.

Enfin, le transistor PMOS 34 peut être remplacé par une résistance intégrée : la surface occupée est alors cependant plus importante.

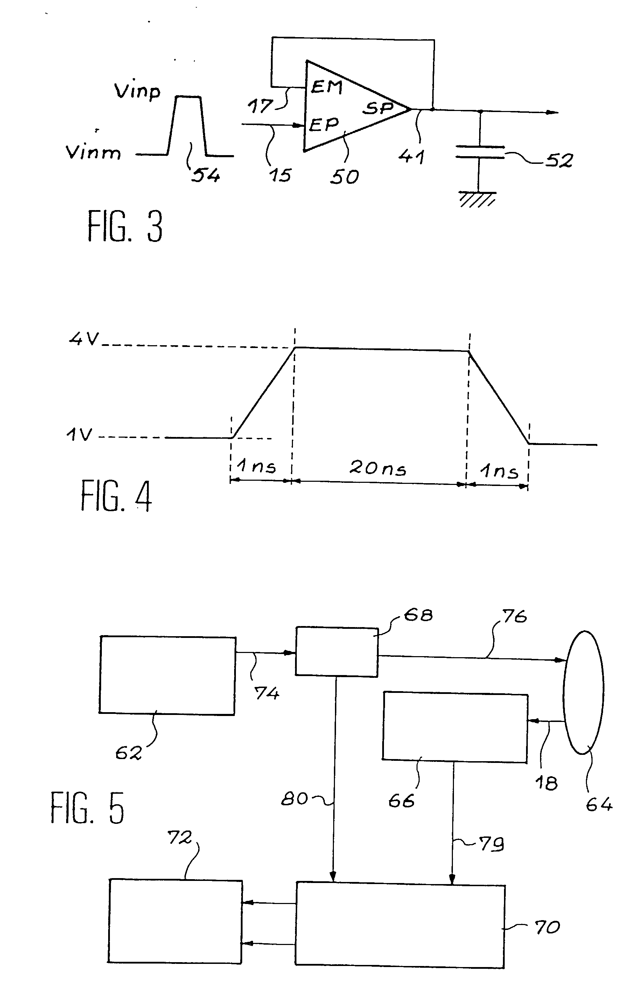

Le fonctionnement du dispositif selon l'invention va être expliqué en liaison avec la figure 3. Sur cette figure, un amplificateur 50 désigne globalement l'ensemble des deux étages décrits de manière plus détaillée ci-dessus. La sortie SP 41 est connectée sur la seconde entrée 17. Il s'agit donc d'un montage en mode suiveur, chargé sur une capacité 52, et attaqué par une impulsion 54.

En mode établi (niveau continu Vᵢₙₘ sur EP), la capacité 32 n'intervient pas. La polarisation du transistor 30 est fixée par le transistor 34, monté en résistance, par la tension base-émetteur du transistor 36 et par (V_{cc}-Vₛₛ). Le courant qui circule dans le transistor 38 est le courant circulant dans le transistor 36 multiplié par le rapport des géométries des transistors 38 et 36, plus une contribution due à l'effet Early sur le transistor 38. La chute de tension aux bornes de la résistance 40 est suffisamment faible pour que l'on puisse négliger l'effet de cette résistance en mode établi.

Lorsque EP passe de Vᵢₙₘ à Vᵢₙₚ (voir impulsion de tension 54 sur la figure 3) le potentiel en sortie 19 du premier étage chute fortement, entraînant une augmentation de la tension grille-source de 30, d'où une augmentation du courant disponible pour la charge 52. Dans le même temps, le front descendant sur 19 est répercuté presque entièrement sur la base du transistor 38 grâce à la capacité 42 et à la résistance 40. Le transistor de polarisation 38 se bloque rapidement, ce qui provoque un accroissement du courant disponible pour la charge de la capacité 52, d'où une forte augmentation du slew-rate de montée.

La résistance 40 sert à modérer le blocage du transistor 36 afin que le système se rétablisse plus rapidement. On note que le courant d'injection circule de 34 vers 18, en passant par la résistance 40 et la capacité 42. En fait, lors de l'injection le courant dans 34 augmente peu, c'est le blocage du transistor 38 qui permet à tout le courant du transistor 34 d'être transmis intégralement dans la capacité 42, d'où une efficacité renforcée.

Lorsque EP passe de Vᵢₙₚ à Vᵢₙₘ, le potentiel en sortie 19 augmente légèrement et réduit le courant dans le transistor 30. Dans le même temps, le front montant sur la sortie 19 est répercuté sur la base du transistor 38 grâce à la capacité 42 et à la résistance 40. Le transistor de polarisation 38 se met à conduire beaucoup plus, ce qui provoque un accroissement du courant disponible pour la décharge de la capacité 52, d'où une augmentation importante du slew-rate de descente.

Le courant dans les transistors 34 et 36 n'est quasiment pas affecté lors de l'injection, à cause de la faible augmentation de la tension base-émetteur du transistor 36. En effet, lors de l'injection, l'augmentation de la tension base-émetteur du transistor 38 n'est pas transmise intégralement sur la base du transistor 36 grâce à la résistance 40. Le courant d'injection est très faible, il passe du transistor 22 à la capacité 42 puis dans la base du transistor 38.

On peut noter que, sans la capacité 42, le slew-rate de descente est fixé par le courant de polarisation et par le temps de fermeture de du transistor 38 ; c'est d'ailleurs ce temps de fermeture qui est rédhibitoire. Le montage à couplage Ac améliore très nettement le slew-rate de descente (facteur 10) du fait que c'est l'augmentation dynamique très rapide du courant de polarisation du transistor 38 qui fixe la slew-rate, et non pas le temps de fermeture du transistor 30.

Le dispositif selon l'invention met en oeuvre une technique de couplage AC dans une structure en boucle fermée ; plus précisément, ce couplage AC est intégré dans l'étage de sortie d'un amplificateur. On peut ainsi combiner l'utilisation de transistors bipolaires NPN très rapides avec un système de commande dynamique.

Le dispositif décrit présente les avantages suivants.

Grâce à la capacité 42 connectée sur la sortie 19, on a une action très rapide sur l'étage de sortie. La capacité 42 permet d'atteindre une bonne coordination des actions sur les transistors 30 et 38, ce qui conduit à un temps de réponse très court, et donc à des slew-rate très importants, que l'on ne peut pas atteindre avec les systèmes classiques.

En plus des très bonnes performances dynamiques, l'amplificateur permet de conserver une bonne précision grâce au gain DC (pouvant être supérieur à 60 dB) et à une bonne stabilité. Les performances atteintes en amplification linéaire sont donc tout à fait correctes.

La dynamique de sortie est également excellente puisque l'on conserve tous les avantages du montage à source commune.

La consommation statique est modérée, car les slew-rate de montée et de descente ne sont pas donnés par des courants de polarisation, mais par des courants dynamiques.

Enfin, la structure proposée est simple et ne nécessite pas d'ajuster les éléments 42 et 40 très précisément. De plus, le dispositif selon l'invention permet d'éviter l'utilisation de transistors bipolaires PNP qui, dans la plupart des technologies BiCMOS, ne sont pas proposés ou sont de mauvaise qualité. L'amplificateur peut être réalisé en technologie BiCMOS 0,8 µm et utiliser les éléments suivants : transistor bipolaire NPN 12 GHz, transistor NMOS et PMOS, résistance POLY et capacité POLY/POLY.

Un circuit à été réalisé avec des transistors MOS 16, 18, 20, 22, 30, 34 ayant les caractéristiques géométriques résumées dans le tableau I ci-dessous, où W et L désignent respectivement la largeur et la longueur de la grille.

Ce circuit est alimenté sous 5 volts et est monté en suiveur de tension, chargé par une capacité 52 de 2pF. La géométrie du transistor 38 est le double de celle du transistor 36. De plus, on choisit les paramètres suivants :
- courant de polarisation Iₚₒₗ égal à 1 mA,
- capacité 32 égale à 0,6 pF,
- capacité 42 à peu près égale à 2,5 pF,
- résistance 40 à peu près égale à 1 kΩ;

Le courant circulant dans la branche définie par les transistors 34 et 36 vaut environ 700 µA, et le courant recopié dans la branche définie par les transistors 30 et 38 vaut environ 1,5 mA.

**TABLEAU I**

| Géo/Trans | 16 | 18 | 20 | 22 | 34 | 30 |
|---|---|---|---|---|---|---|
| W | 70µm | 70µm | 51µm | 51µm | 25µm | 64µm |
| L | 1,2µm | 1,2µm | 1,2µm | 1,2µm | 5µm | 0,8µm |

Pour les paramètres ci-dessus, le tableau II suivant donne les résultats obtenus avec l'impulsion de tension 54 dont les caractéristiques sont données en figure 4. En ce qui concerne la dynamique de sortie, on remarquera que, en mode suiveur, celle-ci se limite à 5 volts/0,9 volts à cause de l'étage d'entrée.

**TABLEAU II**

| Paramètres | Résultats |
|---|---|
| Gain DC | 61dB |
| Marge de Phase | 51 degrés |
| Bande passante | 440MHz |
| Fréquence de coupure -3dB | 420KHz |
| Slew-rate de montée | 2100V/µs |
| Slew-rate de descente | 1600V/µs |
| Temps d'établissement état haut | 1,5ns à 5% |
| Temps d'établissement état bas | 2,2ns à 5% |
| THD à 100MHz sur 1Vpp | -50dB |
| THD à 100MHz sur 2Vpp | -45dB |
| THD à 200MHz sur 1Vpp | -30dB |
| Dynamique de sortie | 5V/0,3V |
| Consommation statique | 16mW |

Le dispositif selon l'invention trouve ses applications notamment dans des dispositifs analogiques traitant des données à large bande passante, et avec une grande précision.

On peut détailler son utilisation dans le cas de la télémétrie laser temps de vol. Un télémètre laser est décrit par exemple dans le document FR-2 725 279.

Ce dispositif de télémétrie comporte conformément à la figure 5, un microlaser à déclenchement passif 62, qui envoie un faisceau lumineux 74 en direction d'un objet 64 dont on veut déterminer la position. Un faisceau 78 réfléchi par cet objet 64 est dirigé vers des moyens optiques 66 de réception d'un faisceau lumineux, comme par exemple un séparateur de faisceau combiné à une lentille de réception. Le faisceau 79 obtenu en sortie des moyens 66 de réception du faisceau réfléchi 78 est dirigé vers un circuit de détection 70 comportant par exemple un composant photodétecteur qui va fournir une impulsion électrique marquant la fin de l'intervalle que l'on doit mesurer pour déterminer le temps de vol du faisceau. Ce circuit comprend en outre une chaîne amplificatrice, qui fournit à un étage comparateur un signal de fin de l'intervalle à mesurer. Ce signal est transmis au dispositif 72 de mesure de temps.

Par ailleurs, le dispositif comporte également des moyens de détection de l'instant d'émission d'une impulsion du microlaser. Ces moyens peuvent comporter par exemple un dispositif 68 de prélèvement d'une partie 80 du flux lumineux du faisceau 74 émis par le microlaser 62, par exemple une lame séparatrice.

D'autres détails concernant notamment le microlaser 62 et le circuit de détection 70 sont donnés dans le document FR-2 725 279.

L'amplificateur selon l'invention est utilisé dans une structure d'échantillonneur/bloqueur boucle ouverte en tant que buffer d'entrée et de sortie entourant une cellule de mémorisation de l'information analogique, constituée par exemple d'une capacité (par exemple de 2pF) et d'un switch CMOS. Ceci est illustré sur la figure 6 représentant une telle structure d'échantillonneur-bloqueur. Les références 82 et 84 désignent chacune un amplificateur suivant la présente invention, monté en suiveur de tension. Une capacité 86 mémorise l'information analogique et un interrupteur 88 CMOS commande l'échantillonnage et le blocage d'un signal d'entrée IN. Dans cette application, on échantillonne et on bloque des rampes qui ont des contraintes très sévères : la rampe envoyée sur l'échantillonneur/bloqueur peut monter de 3V en 1ns, se stabiliser à 4V pendant 4ns, avant de chuter de 3V en 15ns. L'échantillonnage a lieu sur la pente descendante de la rampe et on doit atteindre la précision de 2mV sur cette pente. Il faut donc un slew-rate de montée important (dans certains cas : 1800V/µs au minimum), une stabilisation à la précision de 2mV en 6ns environ, et un gain DC supérieur à 50dB.

Plus généralement, le dispositif amplificateur selon l'invention est particulièrement bien adapté, lorsqu'il est sous charge capacitive, à des applications qui demandent à la fois une bonne précision et une très bonne réponse impulsionnelle à large bande passante, sous forte amplitude.

Le dispositif selon l'invention permet de réaliser une adaptation d'impédance pour augmenter un courant de charge, par exemple sur une capacité. Ceci est important pour différentes applications, comme le suivi de tension (figure 3) ou l'échantillonnage (figure 6).

Il permet ainsi de transmettre le plus rapidement possible des signaux analogiques sans altérer leur forme.

L'architecture globale de l'amplificateur est en boucle fermée si une grande précision est souhaitée.

Du fait de cette boucle fermée, et comme l'on traite des signaux impulsionnels (à large bande passante), on utilise des moyens pour augmenter ou annuler rapidement le courant de sortie, ce qui permet notamment la charge et la décharge d'une capacité, dans les temps requis pour conserver les propriétés du signal à transmettre (transfert du signal précis. On notera que le mode suiveur (illustré en figure 3) est un cas particulier de la structure à boucle fermée, dans laquelle on cherche à recopier le signal appliqué à l'entrée avec une grande précision et à réaliser une adaptation d'impédance, ce qui permet d'augmenter la puissance du signal en sortie. La boucle ouverte peut également être utilisée, pour cette application en mode suiveur, si on ne recherche pas une grande précision sur la recopie du signal.

## Revendications

1. Dispositif de suivi de signaux impulsionnels analogiques, comportant :
- un premier étage (14) ayant une première et une seconde entrées (15, 17) et une sortie (19), cet étage permettant d'amplifier une différence de tension entre un signal (EM) appliqué à la première entrée (15) et un signal (EP) appliqué à la deuxième entrée (17),
- un second étage présentant une entrée et une sortie (41), l'entrée de ce second étage étant connectée à la sortie (19) du premier étage, ce second étage comportant également un transistor (30) polarisé par une source de courant continu (26) ainsi que des moyens (29) pour bloquer la source de courant continu (26) lors du front montant d'une impulsion de tension (EM), et la sortie (41) du second étage étant connectée à la deuxième entrée (17) du premier étage.

2. Dispositif selon la revendication 1, les moyens (42) pour bloquer la source de courant continu (26) lors du front montant d'une impulsion de tension (EM) permettant également d'amplifier le courant de la source de courant continu lors du front descendant d'une impulsion de tension.

3. Dispositif selon l'une des revendications 1 ou 2, comportant en outre des moyens (32) pour stabiliser le transistor (30) du second étage qui est polarisé par la source de courant continu (26).

4. Dispositif selon l'une des revendications 1 à 3, les moyens (28) pour bloquer la source de courant continu, lors du front montant d'une impulsion de tension (EM), comportant une capacité (42) connectée entre la sortie (19) du premier étage (14) et la source de courant (26).

5. Dispositif selon l'une des revendications précédentes, le premier étage (14) comportant des transistors de charge (20, 22) PMOS.

6. Dispositif selon l'une des revendications 1 à 4, le premier étage (14) comportant des transistors de charge (20, 22) de type PNP.

7. Dispositif selon l'une des revendications précédentes, le transistor (30) de l'étage de sortie étant de type PMOS.

8. Dispositif selon l'une des revendications 1 à 6, le transistor (30) de l'étage de sortie étant de type PNP.

9. Dispositif selon l'une des revendications précédentes, la source de courant continu de l'étage de sortie comportant :
- des moyens (34) pour générer un courant de référence,
- des moyens (36) pour recopier ce courant,
- des moyens (38) pour amplifier ce courant.

10. Dispositif selon l'une des revendications précédentes, la source de courant continu de l'étage de sortie comportant deux transistors (36, 38) NPN, dont les bases sont reliées par une résistance (40) et un transistor PMOS (34) relié au collecteur d'un des deux transistors NPN (36);

11. Circuit échantillonneur/bloqueur en boucle ouverte comportant une cellule de mémorisation analogique et un buffer d'entrée et de sortie, ce dernier comportant un dispositif selon l'une des revendications 1 à 10.

12. Dispositif de télémétrie laser, fonctionnant sur le principe de la mesure du temps de vol d'une impulsion lumineuse, caractérisé en ce qu'il comprend :
- un microlaser (62) déclenché,
- des moyens (66, 70) de réception d'une impulsion lumineuse (78, 79) réfléchie par un objet (64) et de détection de l'instant de réception de cette impulsion,
- des moyens (68, 70) de détection de l'instant d'émission d'une impulsion du microlaser (62),
- des moyens (72) de mesure de l'intervalle de temps séparant l'instant d'émission de l'impulsion microlaser de l'instant de réception du faisceau réfléchi, ces moyens de mesure comportant un circuit échantillonneur/bloqueur selon la revendication 11.
